# EUROPEAN PATENT SPECIFICATION

(11) **EP 0 982 741 B1**
(45) Date of publication and mention of the grant of the patent: **15.02.2006**
(21) Application number: 99116525.9
(22) Date of filing: 24.08.1999
(51) Int. Cl.: H01C 17/12

(54) **Method for fabricating a thin film resistor onto a ceramic-polymer substrate**
Herstellungsverfahren für einen Dünnschichtwiderstand auf ein Keramik-Polymersubstrat
Procédé de production d'une résistance à film mince sur un substrat céramique-polymère

(30) Priority: 25.08.1998 US 139193
(43) Date of publication of application: 01.03.2000
(73) Proprietor: Hughes Electronics Corporation, El Segundo, California 90245-0956 (US)
(72) Inventor: Caigoy, Arturo L., Chino Hills, California 91709 (US); Linder, Jacques F., Palos Verdes, California 90275 (US)
(74) Representative: Steil, Christian

(56) References cited:
- EP-A- 0 309 982
- US-A- 4 498 071
- US-A- 5 872 040

## Description

The present invention relates generally to methods of fabricating selected portions of a microwave circuit board and, more particularly, to a method of fabricating a thin film resistor onto a ceramic-polymer substrate, according to the preamble of claim 1 (US-A-5,683,928).

Further, the present invention relates to a corresponding microwave circuit board for use in a satellite, according to the preamble of claim 8.

Integrated circuits and devices require resistors as part of their circuitry. Two basic approaches of fabricating resistors include thick and thin film processes. In the thin film process, a thin film of resistive material is deposited such as by sputter deposition on a substrate. In the thick film process, a coating of resistor paste is formed on a substrate and then fired to make a resistor.

Substrates used, for example, in high power communications satellites have been made primarily of a thick ceramic. During the fabrication of conventional microwave circuit boards having resistors, the ceramic may be exposed to temperatures of up to or in excess of about 800°C. Ceramics are capable of withstanding such temperatures without decomposing or deforming.

It would be advantageous to construct microwave circuit boards from ceramic-polymer substrates, as are, for example, known from EP-A2-0 309 982. Ceramic-polymers are lightweight (e.g., lighter than ceramics) composite materials including generally a ceramic and a polymer. Ceramic-polymers have thermomechanical stability and chemical durability characteristics ideal for circuit boards used in satellites. A variety of other reasons known to those skilled in the art make ceramic-polymers generally preferable over ceramics.

Unlike the ceramics discussed above, however, ceramic-polymers decompose and/or degrade in oxygen environments at temperatures in excess of about 300°C. Thick film resistors require high temperature firing (800°C or more) to apply resistors onto ceramic substrates. Such extreme temperatures would destroy ceramic-polymer substrates.

Prior application of thick film resistors such as nickel ceramic paste on ceramic-polymer substrates at lower firing temperatures have been experimented on, but the results were unstable with inconsistent resistance values. The problem was the inconsistent adhesion quality of the nickel ceramic paste to the ceramic-polymer substrates.

Because of the difficulties associated with depositing a thick film resistor onto a ceramic-polymer substrate, ceramic-polymer microwave boards are typically manufactured using chip resistors. There are, however, significant disadvantages associated with the use of chip resistors.

These disadvantages include detailed and expensive routing and machining steps being required to manufacture chip resistors and to incorporate them into microwave circuit boards. Manufacturing flaws are inevitable during these routing and machining steps and in the manufacture of complete ceramic-polymer microwave circuit boards containing chip resistors.

From US-A-4,498,071 it is known to produce metal film resistors by first depositing an insulative film on a ceramic substrate and then coating the entire surface of the dielectric material with a resistance film. The insulative film makes the surface for the metal film much rougher microscopically and thereby significantly increases the sheet resistance of the resistive film.

Document US-A-5,683,928 discloses a method for the manufacture of resistors on polymer or ceramic surfaces. A dielectric layer being deposited on a substrate carries a layer of tantalum nitride resistors that have been deposited on the dielectric layer by a sputtering operation.

Accordingly, it is an object of the present invention to provide a method of fabricating a thin film resistor onto a ceramic-polymer substrate.

It is another object of the present invention to provide a microwave circuit board fabricated in accordance with the method of the present invention.

The above object is solved by the method of claim 1 and the corresponding circuit board of claim 8, wherein the method includes lapping the surface of the ceramic-polymer substrate until the surface roughness falls in a range between 0.254 µm to 1.016 µm (10 to 40 microinches). The ceramic-polymer substrate is then sputtered with a resistive material from a target positioned within a predetermined distance away from the substrate to deposit a thin film resistor layer over the ceramic-polymer substrate.

The predetermined distance is within or equal to one-half of the diameter of the target.

These and other features, aspects, and embodiments of the present invention will become better understood with regard to the following description, appended claims, and accompanying drawings.
FIGURE 1 is a flow diagram representing operation of a thin film resistor fabrication method in accordance with the present invention;
FIGURE 2 is a diagram illustrating the sputter deposition process of the thin film resistor fabrication method;
FIGURES 3A-3F are cross-sectional views of the fabrication stages of fabricating a thin film resistor onto a ceramic-polymer substrate in accordance with an embodiment of the present invention;
FIGURES 4A-4F are cross-sectional views of the fabrication stages of fabricating a thin film resistor onto a ceramic-polymer substrate in accordance with another embodiment of the present invention; and
FIGURES 5A-5F are cross-sectional views of the fabrication stages of fabricating a thin film resistor onto a ceramic-polymer substrate in accordance with still another embodiment of the present invention.

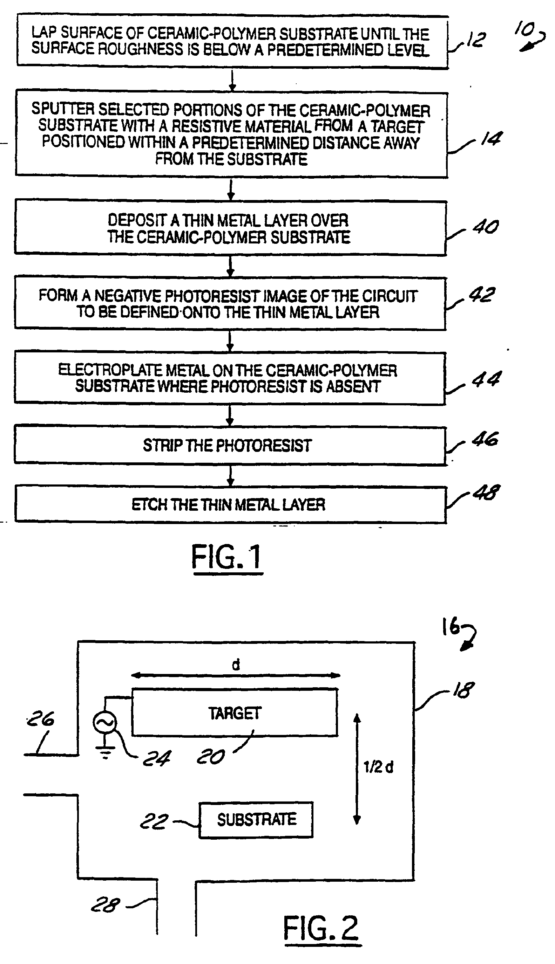

Referring now to Figure 1, a flow diagram 10 representing operation of a thin film resistor fabrication method of the present invention is shown. Flow diagram 10 begins with block 12 lapping the surface of a ceramic-polymer substrate until the surface roughness of the substrate is below a predetermined level. Preferably, the ceramic-polymer substrate is lapped such that the surface roughness falls in a range between 0.254 µm to 1.016 µm (10 to 40 microinches). Most preferably, the surface roughness is below 0.762 µm (30 microinches). Lapping is performed by such process as grinding, polishing, scrubbing, and the like as known to those skilled in the art.

Flow diagram 10 then continues with block 14 sputtering selected portions of the substrate with a resistive material from a target positioned within a predetermined distance away from the substrate. Preferably, the target is positioned within a distance of one-half of the diameter of the target away from the substrate.

Referring now to Figure 2, a diagram illustrating a sputter deposition system 16 for carrying out the process described in block 14 is shown. Sputter deposition system 16 includes a chamber 18. A resistor material target 20 such as tantalum nitride, tantalum oxide, nichrome series of film resistors, and the like is placed in chamber 18. Preferably, target 20 is tantalum nitride and has a diameter (d) as shown.

A ceramic-polymer substrate 22 is also placed in chamber 18. Suitable ceramic-polymer substrates include hydrocarbon mineral composites of a ceramic polymer wherein the ceramic is a barium titanate. Other suitable substrate materials include plastic polytetrafluoroethylene/ceramic.

Substrate 22 is positioned away from target 20 within a distance less than one-half of the diameter (d) of the target. The preferred method of sputtering is radio frequency (RF) reactive sputtering. Accordingly, target 20 is connected to a RF generator 24.

Chamber 18 includes a gas port 26 and a pump port 28. An inert gas such as an argon and nitrogen mixture is introduced into chamber 18 through gas port 26. The charged argon atoms are attracted and accelerate toward target 20. The argon atoms collide with target 20 and knock off molecules from the target. The sputtered molecules from target 20 scatter in chamber 18 and come to rest on substrate 22. A thin film resistor material having a thickness depending upon the deposition rate and the duration of the sputtering then builds up on substrate 22.

A pump (not shown) is connected to pump port 28 for reducing the pressure in chamber 18 to a desired range. The pressure is reduced to maintain low moisture to prevent unwanted oxidation of the deposited film.

The combination of the lapping and the RF reactive sputtering processes results in resistive layers with high adhesion to substrate 22. The RF reactive sputtering process results in all of the fibers of substrate 22 being coated and reliable resistors being formed at the surface of porous substrates.

Referring now back to Figure 1, flow diagram 10. continues with block 40 depositing a thin metal layer over the substrate. The thin metal layer is preferably silver. Block 42 then forms a negative photoresist image of the circuit to be defined onto the metal layer. The photoresist image is aligned with the location of the selected portions of the substrate covered with resistive material. Block 44 then electroplates metal on the substrate where photoresist is absent. Electroplating forms the circuit pattern. Block 46 then strips the photoresist from the substrate. Block 48 then etches the thin metal layer away from the substrate.

Except for the quick thin metal layer etching process of block 48, the process described in flow diagram 10 is essentially all positive. Thus, excessive exposure of the ceramic-polymer substrate to harsh etchants is avoided. (The stripping the photoresist process of block 46 is done with a mild solvent.)

The operation of the thin film resistor fabrication method described in flow diagram 10 will now be described in greater detail with respect to three different embodiments of the present invention.

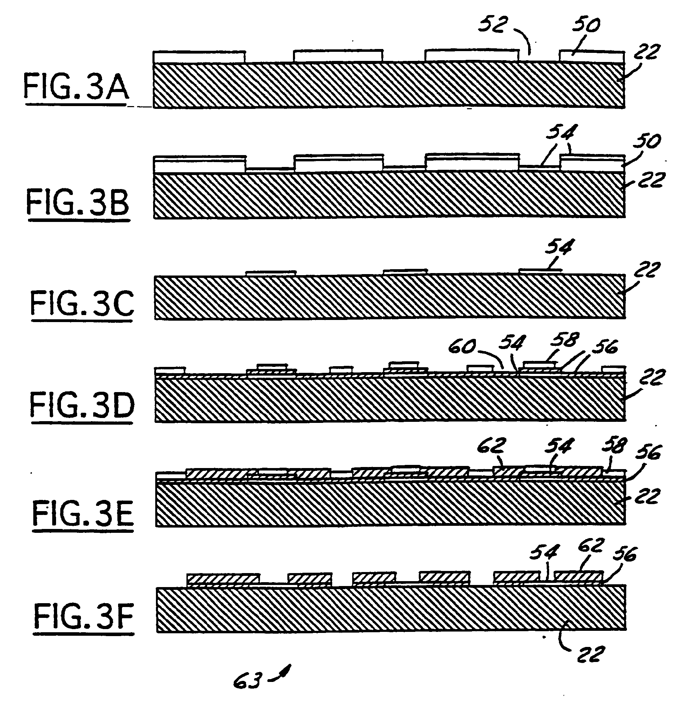

Referring now to Figures 3A-3F, cross-sectional views of the fabrication stages of fabricating a thin film resistor onto a ceramic-polymer substrate 22 in accordance with an embodiment of the present invention is shown. After the surface of substrate 22 is lapped to the predetermined roughness, a photoresist layer 50 is formed on selected portions of the substrate as shown in Figure 3A. Photoresist layer 50 covers the entirety of substrate 22 except in small windows 52 where the substrate is exposed.

A thin film resistor layer 54 such as tantalum nitride is deposited on substrate 22 over windows 52 and photoresist layer 50 as shown in Figure 3B. Thin film resistor layer 54 is deposited by RF reactive sputtering as described above with reference to Figures 1 and 2. Thin film resistor layer 54 is deposited at a given rate for a given period of time to form a film layer having a thickness falling within a desired range. Accordingly, thin film resistor layer 54 has a desired sheet resistance.

Substrate 22 is then immersed in a solvent such as acetone. The solvent softens and lifts off photoresist layer 50 along with the portions of thin film resistor layer 54 on top of photoresist layer 50. Patches of thin film resistor layer 54 remain on substrate 22 where windows 52 existed in photoresist layer 50 as shown in Figure 3C.

A thin metal layer 56, preferably silver, is deposited by sputtering or evaporation over all of substrate 22 as shown in Figure 3D. The thickness of thin silver layer 56, deposited onto substrate 22 falls within a range between 100 to 200 nm [1000 to 2000 angstroms].

A negative photoresist layer 58 is then formed over selected portions of thin silver layer 56 as shown in Figure 3D. Negative photoresist layer 58 forms a photoresist mask having windows 60 for receiving circuit conductors.

A copper and gold layer 62 is then electroplated to substrate 22 on windows 60 of the photoresist mask of negative photoresist layer 58 as shown in Figure 3E. Copper and gold layer 62 form the circuit conductors having openings for the resistors. Copper and gold layer 62 preferably consists of a copper layer having a thickness falling within a range of 250 to 400 micrometers and a gold layer having a thickness falling within a range of 10 to 20 micrometers. The copper layer is initially electroplated onto substrate 22 and then the gold layer is electroplated onto the substrate.

Negative photoresist layer 58 is then stripped as shown in Figure 3F. Further, thin silver layer 56 is then etched as shown in Figure 3F. Preferably, thin silver layer 56 is etched using Ammonium Hydroxide with the addition of Hydrogen Peroxide. Etching thin silver layer 56 eliminates the shorting film. As a result of the processes described with reference to Figures 3A-3F, a working circuit 63 is yielded as shown in Figure 3F.

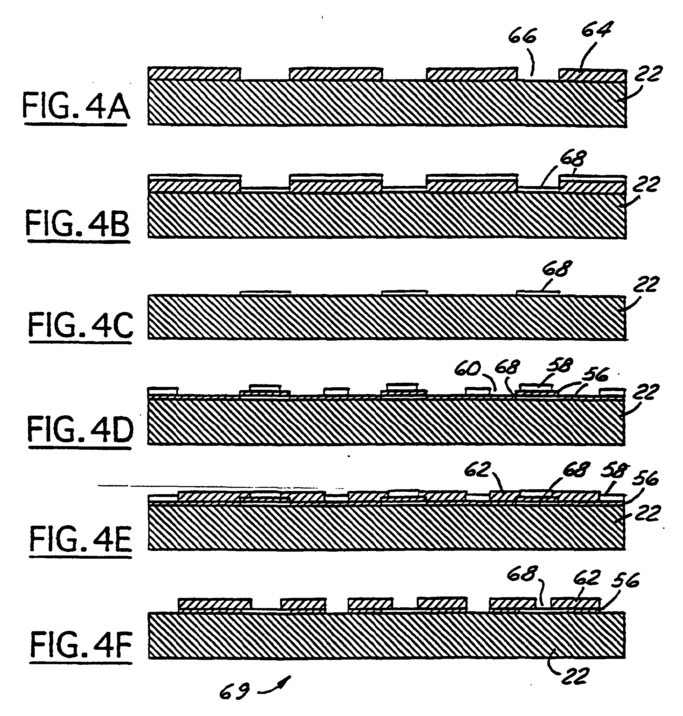

Referring now to Figures 4A-4F, cross-sectional views of the fabrication stages of fabricating a thin film resistor onto substrate 22 in accordance with another embodiment of the present invention is shown. After the surface of substrate 22 is lapped to the predetermined roughness, a metal template 64 having windows 66 is positioned in tight contact over the substrate. Metal template 64 is obtained either by machining a plate with properly located windows 66 or by a photolithographic process. The photolithographic process is performed using a photomask similar to photoresist layer 50 described with reference to Figure 3A. The metal template obtained by using the photolithographic process is a thin bi-metal sheet, yielding a more accurate mask than the machined metal template.

A thin film resistor layer 68 such as tantalum nitride is deposited on substrate 22 over metal template 64, and windows 66 as shown in Figure 4B. Thin film resistor layer 68 is deposited by RF reactive sputtering as described above with reference to Figures 1 and 2.

Metal template 64 is then separated from substrate 22. Patches of thin film resistor layer 68 remain on substrate 22 over windows 66 as shown in Figure 4C.

The processes illustrated in Figures 4D-4F are similar to the processes described above with respect to Figures 3D-3F. Namely, a thin silver layer 56 is deposited by sputtering or evaporation over all of substrate 22 as shown in Figure 4D. A negative photoresist layer 58 having windows 60 is then formed over selected portions of thin silver layer 56 as shown in Figure 4D. A copper and gold layer 62 is then electroplated to substrate 22 on windows 60 of the photoresist mask of negative photoresist layer 58 as shown in Figure 4E. Negative photoresist layer 58 is then stripped as shown in Figure 4F. Further, thin silver layer 56 is then etched as shown in Figure 4F. As a result of the processes described with reference to Figures 4A-4F, a working circuit 69 is yielded as shown in Figure 4F.

Referring now to Figures 5A-5F, cross-sectional views of the fabrication stages of fabricating a thin film resistor onto substrate 22 in accordance with still another embodiment of the present invention is shown. After the surface of substrate 22 is lapped to the predetermined roughness, an alumina template 70 having laser-cut oversized windows 72 is mounted in tight contact with the substrate as shown in Figure 5A. A thin film resistor layer 74 such as tantalum nitride is deposited on substrate 22 over alumina template 70 and windows 72 as shown in Figure 5A. Thin film resistor layer 74 is deposited by RF reactive sputtering as described above with reference to Figures 1 and 2.

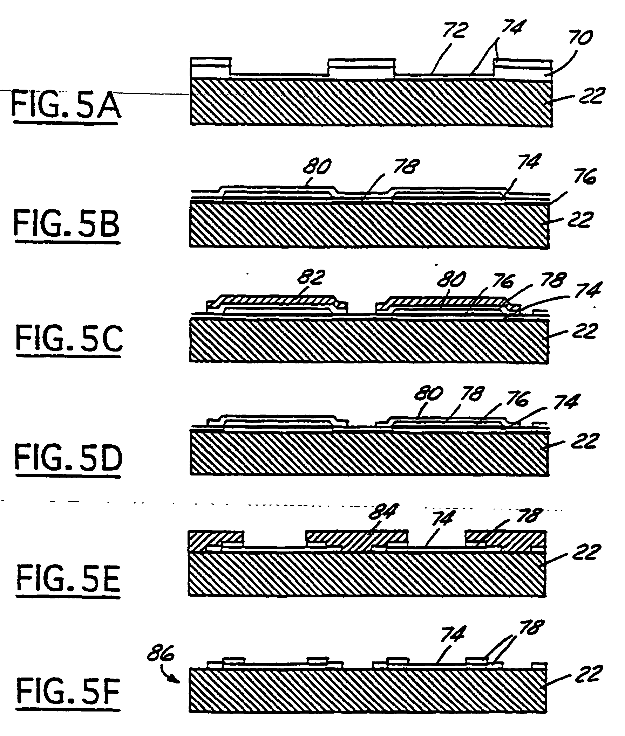

Alumina template 70 is then separated from substrate 22. Patches of thin film resistor layer 74 remain on substrate 22 over windows 72 as shown in Figure 5B.

A thin titanium adhesion layer 76 having a thickness of about 100 nm [1000 angstroms] is deposited over substrate 22 as shown in Figure 5B. A thick gold layer 78 having a thickness of about 1000 nm [10,000 angstroms] is then deposited over substrate 22 as shown in Figure 5B. A titanium film layer 80 is then evaporated over substrate 22 as shown in Figure 5B. Titanium film layer 80 serves as a barrier mask.

A photoresist layer 82 forming a circuit conductor pattern in titanium film layer 80 is then formed on substrate 22 as shown in Figure 5C. Photoresist layer 82 is then etched using a hydrofluoric acid as an etchant to remove selected portions of titanium film layer 80 as shown in Figure 5D.

Using the patterned titanium film layer 80 as a mask, selected portions of gold layer 78 are then etched using reactive ion milling as shown in Figure 5D. The gas used for the ion milling consists of 10% dioxide (O₂) and 90% Argon (Ar).

The unprotected titanium film layer 80 is then wet-etched using hydrofluoric acid as an etchant as shown in Figure 5E. A photoresist layer 84 is then deposited over selected portions of substrate 22 as shown in Figure 5E. The gold conductor lines of gold layer 78 are then opened where the resistors are placed as shown in 5E. Such openings coincide with the patches of thin film resistor layer 74. As a result of the processes described with reference to Figures 5A-5E, a working circuit 86 is yielded as shown in Figure 5F.

Thus it is apparent that there has been provided, in accordance with the present invention, a method of fabricating a thin film resistor onto a ceramic-polymer substrate that fully satisfies the objects, aims, and advantages set forth above.

It is also apparent that there has been provided, in accordance with the present invention, a microwave circuit board fabricated in accordance with the method of the present invention.

While the present invention has been described in conjunction with specific embodiments thereof, it is evident that many alternatives, modifications, and variations will be apparent to those skilled in the art in light of the foregoing description.

As an example of the many alternatives; modifications, and variations, consider the resistors produced by either of the three methods explained above. Instead of forming a circuit around the resistive patches, create contact pads at both ends of each resistor without connecting the circuit. These contact pads are then covered with a protective gold film. The resistive patches can then be annealed and each resistor can then be trimmed to a design value with a laser trimmer. With this approach, built in resistor chips are created.

A thin layer of sacrificial metal is then deposited over the entire substrate to ensure electrical conductivity for electroplating. A photoresist film is then deposited over the substrate and the circuit conductor pattern is defined. A copper layer of a selected thickness is then electroplated to form the conductors. After stripping the photoresist, the sacrificial metal layer is etched away leaving the conductor pattern connecting the previously defined resistors.

## Claims

1. A method of fabricating a thin film resistor (54, 68, 74) onto a ceramic-polymer substrate (22) using a sputtering operation, **characterized by**
lapping (12) the surface of the ceramic-polymer substrate (22) until the surface roughness falls in a range between 0.254 µm to 1.016 µm [10 to 40 microinches]; and
sputtering (14) the ceramic-polymer substrate (22) with a resistive material from a target (20) positioned within a predetermined distance away from the ceramic-polymer substrate (22) to deposit a thin film resistor layer (54, 68, 74) over the ceramic-polymer substrate (22), wherein the predetermined distance is within one-half, preferably equal to one-half, of the diameter (d) of the target (20).

2. The method of claim 1, **characterized in that**
the surface of the ceramic-polymer substrate (22) is lapped until the surface roughness falls below 0.762 µm [30 microinches].

3. The method of any of the preceding claims, **characterized in that**
the ceramic-polymer substrate (22) includes barium titanate or plastic polytetrafluoroethylene/ceramic.

4. The method of any of the preceding claims, **characterized in that**
sputtering (14) the ceramic-polymer substrate (22) with a resistive material is performed using a radio frequency (RF) reactive sputtering system (16).

5. The method of any of the preceding claims, **characterized in that**
the resistive material is tantalum nitride.

6. The method of any of the preceding claims, **characterized by**
placing a photoresist layer (50) having windows (52) over the ceramic-polymer substrate (22) prior to sputtering the ceramic-polymer substrate (22) with a resistive material; and
removing the photoresist layer (50) after sputtering the ceramic-polymer substrate (22) with a resistive material to form thin film resistor layer patches (54) on the ceramic-polymer substrate (22).

7. The method of claim 6, **characterized by**
depositing (40) a silver layer (56) over the ceramic-polymer substrate (22);
placing (42) a second photoresist layer (58) having windows (60) over the thin silver layer (56);
electroplating (44) a copper and gold layer (62) on the ceramic-polymer substrate (22) over the windows (60) of the second photoresist layer (58);
stripping (46) the second photoresist layer (58); and
etching (48) the silver layer (56).

8. A microwave circuit board for use in a satellite, comprising a ceramic-polymer substrate (22) and a thin film resistor layer (54) formed over the ceramic-polymer substrate (22) by sputtering, **characterized in that**
the ceramic-polymer substrate (22) has a lapped surface roughness falling within a range between 0.254 µm to 1.016 µm [10 to 40 microinches] and the thin film resistor layer (54) is formed over the ceramic-polymer substrate (22) by sputtering the ceramic-polymer substrate (22) with a resistive material from a target (20) positioned within a predetermined distance away from the ceramic-polymer substrate (22), wherein the predetermined distance is within one-half, preferably equal to one-half, of the diameter (d) of the target (20).

## Patentansprüche

1. Verfahren zum Herstellen eines Dünnfilmwiderstandes (54, 68, 74) auf einem Keramik/Polymer-Substrat (22) unter Verwendung eines Sputtervorganges, **gekennzeichnet durch**
Läppen (12) der Oberfläche des Keramik/Polymer-Substrates (22), bis die Oberflächenrauigkeit in einem Bereich zwischen 0,254 µm und 1,016 µm [10 bis 40 Mikrozoll] fällt; und
Sputtern (14) eines Widerstandsmaterials auf das Keramik/Polymer-Substrat (22), und zwar aus einem Target (20), das innerhalb einer vorbestimmten Distanz entfernt von dem Keramik/Polymer-Substrat (22) angeordnet ist, um über das Keramik/Polymer-Substrat (22) eine Dünnfilmwiderstandsschicht (54, 68, 74) abzuscheiden, wobei die vorbestimmte Distanz innerhalb einer Hälfte, vorzugsweise gleich einer Hälfte des Durchmessers (d) des Targets (20) ist.

2. Verfahren nach Anspruch 1, **dadurch gekennzeichnet, dass** die Oberfläche des Keramik/Polymer-Substrates (22) geläppt wird, bis die Oberflächenrauigkeit unter 0,762 µm [30 Mikrozoll] fällt.

3. Verfahren nach einem der vorherstehenden Ansprüche, **dadurch gekennzeichnet, dass** das Keramik/Polymer-Substrat (22) Bariumtitanat oder Polytetrafluorethylen-Kunststoff/Keramik aufweist.

4. Verfahren nach einem der vorhergehenden Ansprüche, **dadurch gekennzeichnet, dass** das Sputtern (14) eines Widerstandsmaterials auf das Keramik/Polymer-Substrat (22) unter Verwendung eines reaktiven Sputtersystems (16) im Funkfrequenzbereich (RF) durchgeführt wird.

5. Verfahren nach einem der vorhergehenden Ansprüche, **dadurch gekennzeichnet, dass** das Widerstandsmaterial Tantalnitrid ist.

6. Verfahren nach einem der vorhergehenden Ansprüche, **gekennzeichnet durch**
Anordnen einer Photoresistschicht (50) mit Fenstern (52) über dem Keramik/Polymer-Substrat (22), und zwar vor dem Sputtern eines Widerstandsmaterials auf das Keramik/Polymer-Substrat (22); und
Entfernen der Photoresistschicht (50) nach dem Sputtern eines Widerstandsmaterials auf das Keramik/Polymer-Substrat (22), um so Dünnfilmwiderstandsschichtflecken (54) auf dem Keramik/Polymer-Substrat (22) zu bilden.

7. Verfahren nach Anspruch 6, **gekennzeichnet durch**:
Abscheiden (40) einer Silberschicht (56) auf dem Keramik/Polymer-Substrat (22);
Anordnen (42) einer zweiten Photoresistschicht (58) mit Fenstern (60) auf der dünnen Silberschicht (56);
Elektroplatieren (44) einer Kupfer- und Goldschicht (62) auf dem Keramik/Polymer-Substrat (22), und zwar über den Fenstern (60) der zweiten Photoresistschicht (58);
Abstreifen (46) der zweiten Photoresistschicht (58); und
Ätzen (48) der Silberschicht (56).

8. Mikrowellenleiterplatte zur Verwendung in einem Satelliten, mit einem Keramik/Polymer-Substrat (22) und einer Dünnfilmwiderstandsschicht (54), die durch Sputtern auf dem Keramik/Polymer-Substrat (22) gebildet ist, **gekennzeichnet dadurch, dass**
das Keramik/Polymer-Substrat (22) eine geläppte Oberflächenrauigkeit aufweist, die in einen Bereich zwischen 0,254 µm bis 1,016 µm [10 bis 40 Mikrozoll] fällt, und dass die Dünnfilmwiderstandsschicht (54) auf dem Keramik/Polymer-Substrat (22) gebildet ist durch Sputtern eines Widerstandsmaterials auf das Keramik/Polymer-Substrat (22), und zwar aus einem Target (20), das innerhalb einer vorbestimmten Distanz entfernt von dem Keramik/Polymer-Substrat (22) angeordnet ist, wobei die vorbestimmte Distanz innerhalb einer Hälfte, vorzugsweise gleich einer Hälfte des Durchmessers (d) des Targets (20) ist.

## Revendications

1. Procédé de fabrication d'une résistance à film mince (54, 68, 74) sur un substrat en céramique-polymère (22) en utilisant une opération de pulvérisation cathodique, **caractérisé par** les étapes consistant à :
roder (12) la surface du substrat en céramique-polymère (22) jusqu'à ce que la rugosité de surface se situe dans une plage de 0,254 µm à 1,016 µm [10 à 40 micropouces] ; et
déposer par pulvérisation cathodique (14) un matériau résistif sur le substrat en céramique-polymère (22) à partir d'une cible (20) positionnée à une distance prédéterminée du substrat en céramique-polymère (22) afin de déposer une couche de résistance à film mince (54, 68, 74) sur le substrat en céramique-polymère (22), la distance prédéterminée étant égale à moins de la moitié, de préférence égale à la moitié, du diamètre (d) de la cible (20).

2. Procédé selon la revendication 1, **caractérisé en ce que**
la surface du substrat en céramique-polymère (22) est rodée jusqu'à ce que la rugosité de surface soit inférieure à 0,762 µm [30 micropouces].

3. Procédé selon l'une quelconque des revendications précédentes, **caractérisé en ce que**
le substrat en céramique-polymère (22) comprend du titanate de baryum ou du polytétrafluoroéthylène plastique et de la céramique.

4. Procédé selon l'une quelconque des revendications précédentes, **caractérisé en ce que**
le dépôt par pulvérisation cathodique (14) d'un matériau résistif sur le substrat en céramique-polymère (22) se fait en utilisant un système de pulvérisation cathodique réactif radiofréquence (RF) (16).

5. Procédé selon l'une quelconque des revendications précédentes, **caractérisé en ce que**
le matériau résistif est du nitrure de tantale.

6. Procédé selon l'une quelconque des revendications précédentes, **caractérisé par** les étapes consistant à :
placer une couche de vernis épargne photosensible (50) ayant des fenêtres (52) sur le substrat en céramique-polymère (22) avant de déposer un matériau résistif par pulvérisation cathodique sur le substrat en céramique-polymère (22) ; et
enlever la couche de vernis épargne photosensible (50) après avoir déposé par pulvérisation cathodique un matériau résistif sur le substrat en céramique-polymère (22) afin de former des pastilles de couche de résistance à film mince (54) sur le substrat en céramique-polymère (22).

7. Procédé selon la revendication 6, **caractérisé par** les étapes consistant à :
déposer (40) une couche d'argent (56) sur le substrat en céramique-polymère (22) ;
placer (42) une deuxième couche de vernis épargne photosensible (58) ayant des fenêtres (60) sur la couche d'argent mince (56) ;
déposer galvaniquement (44) une couche de cuivre et d'or (62) sur le substrat en céramique-polymère (22) sur les fenêtres (60) de la deuxième couche de vernis épargne photosensible (58) ;
enlever (46) la deuxième couche de vernis épargne photosensible (58) ; et
graver (48) la couche d'argent (56).

8. Circuit imprimé hyperfréquence destiné à être utilisé dans un satellite, comprenant un substrat en céramique-polymère (22) et une couche de résistance à film mince (54) formée par pulvérisation cathodique sur le substrat en céramique-polymère (22), **caractérisé en ce que**
le substrat en céramique-polymère (22) a une rugosité de surface rodée dans la plage de 0,254 µm à 1,016 µm [10 à 40 micropouces] et la couche de résistance à film mince (54) est formée sur le substrat en céramique-polymère (22) en déposant par pulvérisation cathodique un matériau résistif sur le substrat en céramique-polymère (22) à partir d'une cible (20) positionnée à une distance prédéterminée du substrat en céramique-polymère (22), la distance prédéterminée étant égale à moins de la moitié, de préférence égale à la moitié, du diamètre (d) de la cible (20).
